(19) Europäisches Patentamt

European Patent Office

Office européen des brevets

(11) Veröffentlichungsnummer: **0 282 975 B1**

(12) **EUROPÄISCHE PATENTSCHRIFT**

(45) Veröffentlichungstag der Patentschrift: 09.10.91

(51) Int. Cl.⁵: **G11C 8/00**, G11C 29/00

(21) Anmeldenummer: **88104113.1**

(22) Anmeldetag: **15.03.88**

(54) **Mehrstufige integrierte Dekodereinrichtung.**

(30) Priorität: 16.03.87 DE 3708523
16.03.87 DE 3708525

(43) Veröffentlichungstag der Anmeldung:
21.09.88 Patentblatt 88/38

(45) Bekanntmachung des Hinweises auf die
Patenterteilung:
09.10.91 Patentblatt 91/41

(84) Benannte Vertragsstaaten:
**AT DE FR GB IT NL**

(56) Entgegenhaltungen:
**EP-A- 0 115 187**
**EP-A- 0 117 903**
**EP-A- 0 206 844**

**THE 10TH INTERNATIONAL SYMPOSIUM ON FAULT-TOLERANT COMPUTING, Digest of Papers FTCS-10, 1.-3. Oktober 1980, "Catalog" Nr. 80CH1604-8, Seiten 131-136, IEEE, New York, US; HONG et al.: "FITPLA: a programmable logic array for function independent testing"**

**IBM TECHNICAL DISCLOSURE BULLETIN, Band 27, Nr. 4B, September 1984, Seiten 2439-2441, New York, US; PROEBSTER et al.:**

"High-speed chip card reading"

(73) Patentinhaber: **SIEMENS AKTIENGESELL- SCHAFT**
**Wittelsbacherplatz 2**
**W-8000 München 2(DE)**

(72) Erfinder: **Paul, Manfred, Dipl.-Ing.**
**Fichtenstrasse 18**
**W-8043 Unterföhring(DE)**
Erfinder: **Hoffmann, Kurt, Dr. Prof.**
**Nelkenweg 20**
**W-8028 Taufkirchen(DE)**
Erfinder: **Kowarik, Oskar, Dr. rer. nat.**
**Goethering 70**
**W-8018 Grafing(DE)**
Erfinder: **Kraus, Rainer, Dipl.-Phys.**
**Weidener Strasse 21**
**W-8000 München 83(DE)**

## Beschreibung

Die vorliegende Erfindung betrifft eine mehrstufige integrierte Dekodereinrichtung nach dem Oberbegriff des Patentanspruches 1.

Eine gattungsgemäße Einrichtung ist aus folgenden Veröffentlichungen bekannt:

a) IEEE JOURNAL OF SOLID-STATE CIRCUITS, VOL. SC-18, NO.5, OCT. 1983, Seiten 457 bis 462, "A 70 ns High Density 64K CMOS Dynamic RAM" und

b) 1986 IEEE International Solid-State Circuits Conference, Seiten 260 bis 261 und 365; "A 47 ns 64KW x 4b CMOS DRAM with Relaxed Timing Requirements".

In beiden Veröffentlichungen sind im Zusammenhang mit integrierten Halbleiterspeichern gattungsgemäße Einrichtungen geoffenbart. Sie lassen sich sowohl (ebenso wie die vorliegende Erfindung) als Wort- wie auch als Bitleitungsdekoder einsetzen. Sie enthalten (zumindest andeutungsweise) im wesentlichen drei Gruppen von Teilschaltungen: Vordekoder, Hauptdekoder und Nachdekoder. Die vorliegende Erfindung geht von den Teilen aus, die Vor- und Hauptdekoder betreffen. Sie läßt sich selbstverständlich, was jedem Fachmann einleuchtet, mit Nachdekodern im Sinne der obengenannten Veröffentlichungen kombinieren.

Aufgabe der vorliegenden Erfindung ist es, gattungsgemäße Dekodereinrichtungen mit möglichst einfachen Mitteln so zu erweitern, daß sie es ermöglichen, je nach Anwendungsfall mehr als eine Wortleitung bzw. Bitleitung beispielsweise eines Blockes von Speicherzellen eines Halbleiterspeichers gleichzeitig, d.h. parallel zueinander anzusprechen.

Diese Aufgabe wird gelöst bei einer gattungsgemäßen Dekodereinrichtung durch die kennzeichnenden Merkmale des Patentanspruches 1. Vorteilhafte Aus- und Weiterbildungen sind in Unteransprüchen gekennzeichnet.

In diesem Zusammenhang wird ausdrücklich darauf hingewiesen, daß die vorliegende Erfindung auch mit der vorteilhaften Dekodereinrichtung nach dem prioritätsgleich angemeldeten Schutzrecht EP-A-0 283 908 kombinierbar ist. Besonders gut anwenden lassen sich diese Erfindungen in Verbindung mit den ebenfalls prioritätsgleichen Anmeldungen EP-A-0 282 976, EP-A-0 286 852, EP-A-0 283 906 und EP-A-0 283 907

Die Erfindung wird nun anhand der Figuren näher erläutert. Es zeigen:

Fig. 1 eine Dekodereinrichtung nach dem Stand der Technik.

Die Fig. 2 bis 6 vorteilhafte Ausgestaltungen der vorliegenden Erfindung.

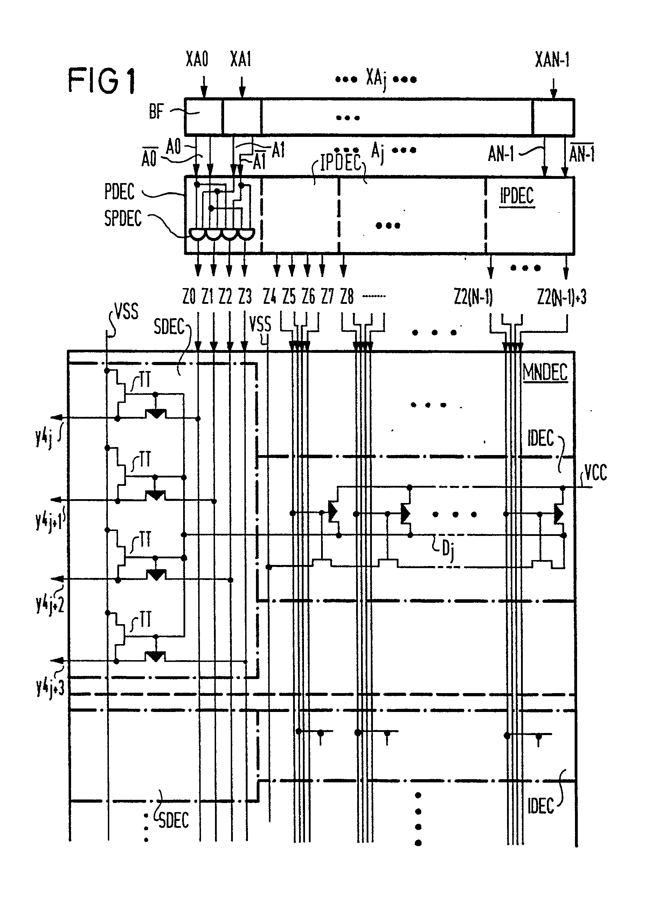

Zur Funktionsweise einer Dekodereinrichtung nach dem Stande der Technik, wie sie beispielsweise in Fig. 1 dargestellt ist, wird im folgenden nur kurz eingegangen. Einem Fachmann auf dem betreffenden Fachgebiet ist dies wohl bekannt.

In einer Bufferschaltung BF werden Adreß-Eingangssignale XAO bis beispielsweise XAN-1 (N ist geradzahlig) zwischengespeichert und gegebenenfalls (wie hier angenommen) als wahre Adressen AO bis AN-1 und dazu komplementäre Adressen $\overline{AO}$ bis $\overline{AN-1}$ weitergegeben an den Vordekoder PDEC. Der Vordekoder PDEC ist eingeteilt in einen Selektionsvordekoder SPDEC und in beispielsweise (N/2)-1 innere Vordekoder IPDEC. Es könnten auch (bei geeignetem Wert für N) (N/3)-1 oder ähnlich viele innere Vordekoder IPDEC sein. Beim Stand der Technik nach Fig. 1 sind der Selektionsvordekoder SPDEC und die inneren Vordekoder IPDEC alle gleich. Es handelt sich dabei jeweils um einen sog. 1-aus-n-Dekoder (im konkreten Beispiel ist n gleich zwei voneinander unabhängigen Adressen Aj).

Dem Vordekoder PDEC nachgeschaltet ist ein Hauptdekoder MNDEC. Er weist eine Anzahl von Selektionsdekodern SDEC und von inneren Dekodern IDEC auf. Je ein Selektionsdekoder SDEC und ein innerer Dekoder IDEC sind einander funktionell und elektrisch zugeordnet. Während die inneren Dekoder IDEC von den Ausgangssignalen Z4... der inneren Vordekoder IPDEC angesteuert werden, werden die Selektionsdekoder SDEC von den Ausgangssignalen Z0 bis Z3 des Selektionsvordekoders SPDEC angesteuert. Im Falle des Einsatzes als Bitleitungsdekoder steuert jedes Ausgangssignal Y4j ... eines Selektionsdekoders SDEC über ein nicht dargestelltes Transfertransistorpärchen genau eine Bitleitung beispielsweise eines Blockes von Speicherzellen des Halbleiterspeichers an.

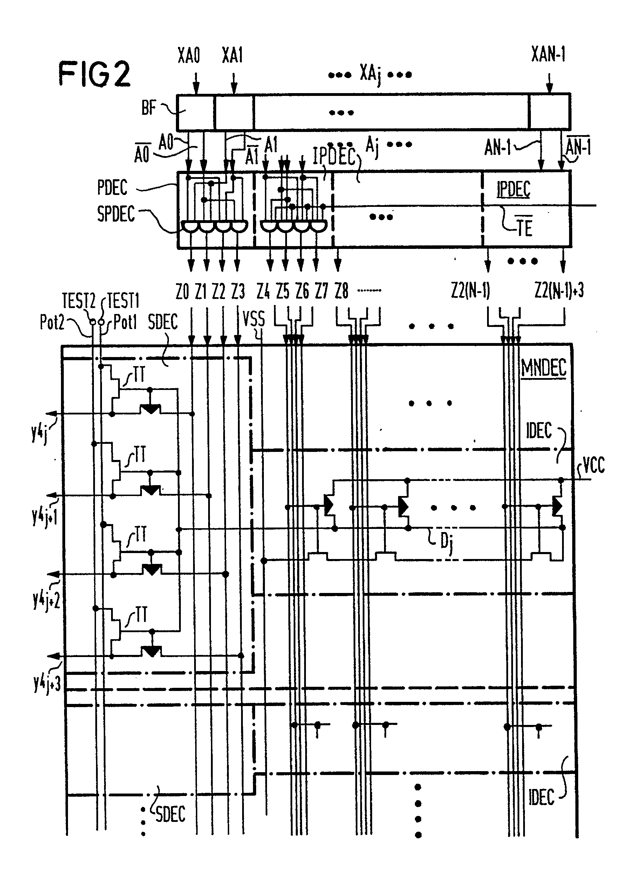

Die erfindungsgemäße Dekodereinrichtung nach den Fig. 2 bis 6 unterscheidet sich von der nach dem Stande der Technik (siehe Fig. 1) in folgenden zwei Punkten:

a) Jedem internen Vordekoder IPDEC (er enthält $2^n$ logische Gatter mit jeweils n Eingängen für entweder eines von n Adreßsignalen Ai oder ein dazu komplementäres Adreßsignal $\overline{Ai}$) ist über einen weiteren Eingang ein Test-Enable-Signal $\overline{TE}$ zugeführt, das im vorliegenden Beispiel bei ansonsten angenommener positiver Logik ("Active high") mit negativer Logik arbeitet ("Active low"). Im Testfall (Test-Enable-Signal $\overline{TE}$ ist aktiv) läßt sich so erreichen, daß keines der Ausgangssignale Z4 ... der internen Vordekoder IPDEC den Wert log. 1 annimmt, d.h. "aktiv wird" (als Bestandteile der internen Vordekoder IPDEC sind AND-Gatter gezeigt; selbstverständlich sind auch andere Logikfunktionen möglich wie z.B. NOR-Gatter bei entsprechender Änderung der Logikansteuerung). Damit nimmt in jedem der inneren Dekoder IDEC eine dort vorhandene Vorauswahlleitung Dj sicher den Wert log. 1 an, der ja üblicherweise dem Versorgungspotential VCC eines modernen integrierten Schaltkreises entspricht. Damit schaltet jedoch jeder der in den Selektionsdekodern SDEC enthaltenen n-Kanal-Transfertransistoren TT durch.

b) Beim Stande der Technik (siehe Fig. 1) sind die Ausgänge jedes Selektionsdekoders SDEC über die Sourceanschlüsse dieser Transfertransistoren TT schaltbar mit dem Bezugspotential VSS verbunden. Erfindungsgemäß sind die Sources einer ersten Hälfte der Transfertransistoren TT jedoch mit einer ersten Potentialleitung Pot1 verbunden und eine zweite Hälfte der Transfertransistoren TT mit einer zweiten Potentialleitung Pot2. Beide Potentialleitungen Pot1, Pot2 weisen unabhängig voneinander je nach Ansteurerung einen von zwei zueinander komplementären Pegeln auf. Beispielsweise weisen beide im Normalbetrieb das Bezugspotential VSS auf, was die übliche Ansteuerung von Bitleitungen eines Halbleiterspeichers ermöglicht. Im Testbetrieb, bei dem beispielsweise nur jede zweite Bitleitung gleichzeitig aktiviert sein soll (paralleles Einschreiben bzw. Auslesen für Prüfmuster Checkerboard; es könnten auch die Wortleitungen angeschlossen sein), liegen an der ersten Potentialleitung Pot1 als logischer Pegel das Versorgungspotential VCC des Halbleiterspeichers an und an der zweiten Potentialleitung Pot2 als logischer Pegel das Bezugspotential VSS an. Entsprechende Pegel weisen im Testfall auch die Ausgänge der Selektionsdekoder SDEC auf.

Es ist vorteilhaft (siehe Fig. 2), daß an den beiden Potentialleitung Pot1, Pot2, Testsignale TEST1, TEST2 anliegen deren logische Pegel unabhängig voneinander einstellbar sind, beispielsweise auf die Werte Versorgungspotential VCC und Bezugspotential VSS.

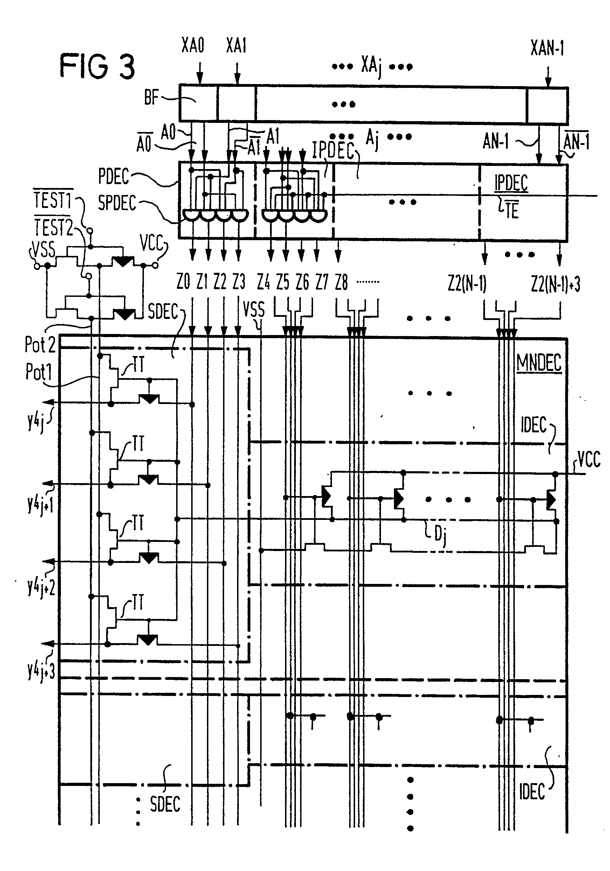

In einer weiteren Ausführungsform (siehe Fig. 3) ist es weiterhin vorteilhaft, daß die Testsignale TEST1, TEST2 Ausgangssignale von CMOS-Invertern sind, die eingangsmäßig jeweils mit einem ersten bzw. einem zweiten Test-Hilfssignal $\overline{TEST1}$, $\overline{TEST2}$ beschaltet sind und die sourcemäßig zwischen Versorgungspotential VCC und Bezugspotential VSS geschaltet sind.

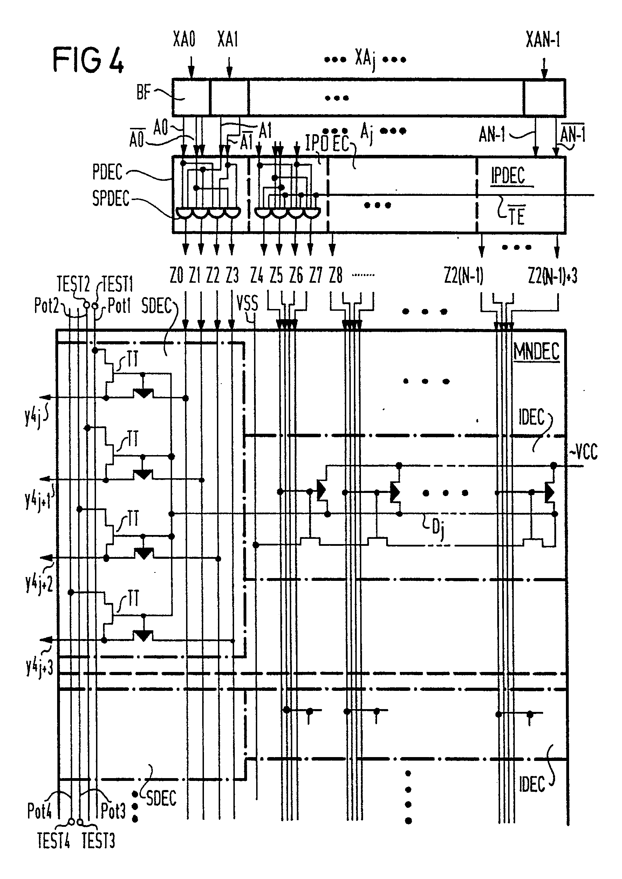

In vorteilhafter Weiterbildung der Erfindung (Fig. 4) ist je Selektionsdecoder SDEC, allgemein ausgedrückt, wenigstens eine Gruppe von Ausgängen Y4j... bis maximal jeder der Ausgänge Y4j ... über den Sourceanschluß des mit dem jeweiligen Ausgang zugehörigen Transfertransistors TT mit einer eigenen Potentialleitung Pot1 ... Pot4 verbunden. Alle Potentialleitungen Pot1 bis Pot4 weisen unabhängig voneinander je nach Ansteuerung jeweils einen von zwei zueinander komplementären logischen Pegeln auf.

Dies hat den Vorteil, daß außer dem Prüfmuster Checkerboard ('1010') auch kompliziertere checkerboard-ähnliche Prüfmuster (z.B. '11001100') testbar sind; ebenso ganz einfache Prüfmuster wie "All 1 's".

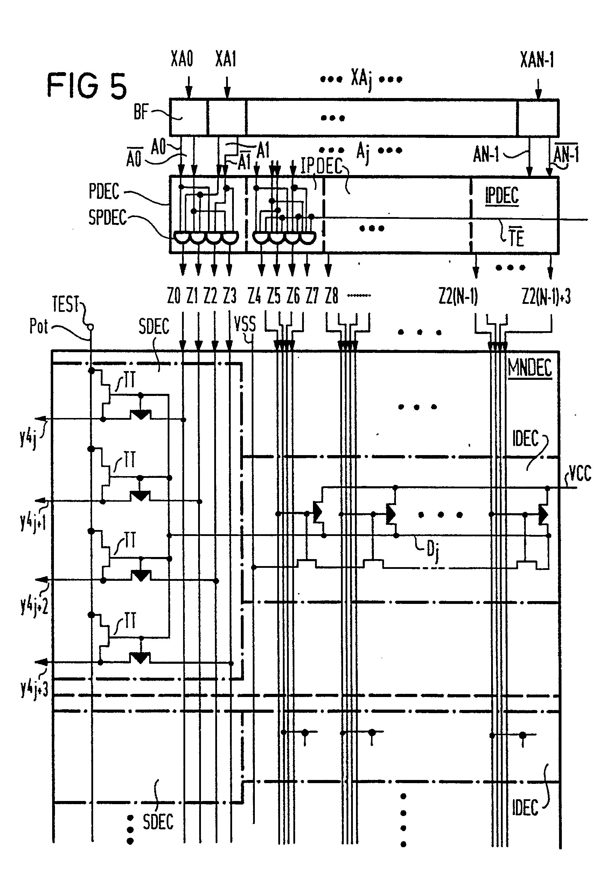

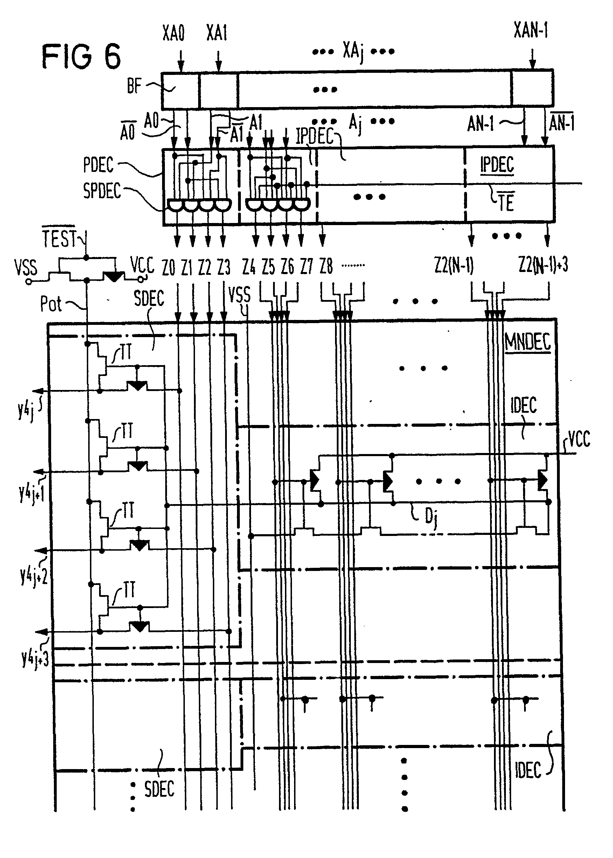

Die FIG 5 und 6 zeigen vereinfachte, vorteilhafte Ausführungsformen. Die Ausführungsform nach FIG 5 enthält anstelle der wenigstens zwei Potentialleitungen Pot1, Pot2 nur eine einzige Potentialleitung Pot. An der einen Potentialleitung Pot sind jeder Ausgang Y4j,Y4j + 1, ... jedes Selektionsdekoders SDEC über den Sourceanschluß eines Transfertransistors TT angeschlossen.

Die Ausführungsform nach FIG 6 kombiniert die Ausführungsformen nach den FIG 3 und 5. Ihre Funktionsweise ist für den Fachmann in Verbindung mit den obenstehenden Ausführungen selbsterklärend.

Die Ausführungsformen nach den FIG 5 und 6 schränken zwar die obengenannte Anzahl der verwendbaren Prüfmuster ein. Sie bieten dafür jedoch den Vorteil des einfacheren und platzsparenderen Aufbaus (Wegfall wenigstens einer üblicherweise viel Raum einnehmenden Potentialleitung).

Ein wichtiger Vorteil der vorliegenden Erfindung besteht bei Verwendung als Bitleitungsdekoder in der Möglichkeit, auch Redundanzspeicherzellen testen zu können, ohne daß der sonst übliche Redundanzmechanismus (z. B. über Laser-Links) aktiviert zu sein braucht (was meist irreversibel ist): Dadurch, daß sich mit der vorliegenden Erfindung die (nicht dargestellten) Trenntransistoren aller Bitleitungen beispielsweise parallel aktivieren lassen, werden auch diejenigen der Redundanzbitleitungen aktiviert.

**Patentansprüche**

1. Mehrstufige integrierte Dekodereinrichtung, enthaltend wenigstens
   - eine Vordekodereinrichtung (PDEC) mit Selektionsvordekoder (SPDEC) und internen Vordekodereinheiten (IPDEC),
     - der Selektionsvordekoder und jede interne Vordekodereinheit sind als 1-aus-n-Dekoder ausgelegt,
   - und eine Hauptdekodereinrichtung mit (MNDEC) mehreren Selektionsdekodern (SDEC) und inneren Dekodern (IDEC),
   
   **gekennzeichnet durch** folgende Merkmale:
   - Allen internen Vordekodereinheiten (IPDEC) ist ein Test-Enable-Signal ($\overline{TE}$) zugeführt, das bei Aktivieren sämtliche Ausganssignale (Z4,Z5,Z6,Z7;Z8,...; ...;Z2(N-1), ..., Z2(N-1) + 3) aller internen Vordekodereinheiten (IPDEC) deaktiviert,
- eine erste Hälfte (Y4j,Y4j + 2) der Ausgänge jedes Selektionsdecoders (SDEC) ist über die Sourceanschlüsse von Transfertransistoren (TT) mit einer ersten Potentialleitung (Pot1) verbunden und eine zweite Hälfte (Y4j + 1,Y4j + 3) der Ausgänge jedes Selektionsdecoders (SDEC) ist über Sourceanschlüsse von Transfertransistoren (TT) mit einer zweiten Potentialleitung (Pot2) verbunden,
- beide Potentiale (Pot1, Pot2) weisen unabhängig voneiander einen von zwei zueinander komplementären logischen Pegeln auf.

2. Mehrstufige integrierte Dekodereinrichtung nach Anspruch 1, **dadurch gekennzeichnet,** daß jede interne Vordekodereinheit (IPDEC) $2^n$ logische Gatter enthält mit n Eingängen für entweder eines von n Adreßsignalen (Ai) oder ein dazu komplementäres Adreßsignal ($\overline{Ai}$) sowie einen weiteren Eingang für das Test-Enable-Signal ($\overline{TE}$), der den Ausgang jedes Gatters unabhängig von der aktuell anliegenden Signalkombination an den restlichen n Eingängen deaktiviert.

3. Mehrstufige integrierte Dekodereinrichtung nach Anspruch 1 oder 2, **dadurch gekennzeichnet,** daß an den Potentialleitungen (Pot1, Pot 2) Testsignale (TEST1, TEST2) anliegen, deren logische Pegel unabhängig voneinander einstellbar sind.

4. Mehrstufige integrierte Dekodereinrichtung nach Anspruch 3, **dadurch gekennzeichnet,** daß die Testsignale (TEST1, TEST2) Ausgangssignale jeweils eines CMOS-Inverters sind, der eingangsmäßig jeweils mit einem Test-Hilfssignal ($\overline{TEST1}$, $\overline{TEST2}$) beschaltet ist und der sourcemäßig zwischen Versorgungspotential (VCC) und Bezugspotential (VSS) geschaltet ist.

5. Mehrstufige integrierte Dekodereinrichtung nach einem der vorhergehenden Ansprüche, **dadurch gekennzeichnet,** daß wenigstens eine Gruppe von Ausgängen bis maximal jeder der Ausgänge (Y4j, ...) jedes Selektionsdekoders (SDEC) über den Sourceanschluß des jeweils zugehörigen Transfertransistors (TT) mit einer eigenen Potentialleitung (Pot1, Pot2, Pot3, Pot4) verbunden ist und daß diese Potentialleitungen (Pot1,Pot2,Pot3,Pot4) unabhägngig voneinander jeweils einen von zwei zueinander komplementäre logische Pegel aufweisen.

6. Mehrstufige integrierte Dekodereinrichtung nach einem der Ansprüche 1 bis 5, **dadurch gekennzeichnet,** daß sie anstelle der zwei Potentialleitungen (Pot1,Pot2) lediglich eine einzige Potentialleitung (Pot) aufweist, die wahlweise einen von zwei zueinander komplementären logischen Pegeln aufweist, und daß jeder Ausgang (Y4j,Y4j + 1, ...) jedes Selektionsdekoders (SDEC) über den Sourceanschluß eines Transfertransistors (TT) mit dieser Potentialleitung (Pot) verbunden ist.

**Claims**

1. Multi-stage integrated decoder device containing at least
   - a preliminary decoder device (PDEC) with selection preliminary decoder (SPDEC) and internal preliminary decoder units (IPDEC),
     - the selection preliminary decoder and each internal preliminary decoder unit are designed as 1-from-n decoders,
   - and a main decoder device (MNDEC) with a plurality of selection decoders (SDEC) and internal decoders (IDEC),
   characterised by the following features:
   - a test-enable signal ($\overline{TE}$) is supplied to all internal preliminary decoder units (IPDEC), which signal deactivates all internal preliminary decoder units (IPDEC) with activation of all output signals (Z4, Z5, Z6, Z7; Z8, ...; ...; Z2(N-1), ..., Z2(N-1) + 3),
   - a first half (Y4j, Y4j + 2) of the outputs of each selection decoder (SDEC) is connected via the source terminals of transfer transistors (TT) to a first potential line (Pot1) and a second half (Y4j + 1, Y4j + 3) of the outputs of each selection decoder (SDEC) is connected via source terminals of transfer transistors (TT) to a second potential line (Pot2),
   - both potentials (Pot1, Pot2) have independently of one another one of two mutually complementary logic levels.

2. Multi-stage integrated decoder device according to Claim 1, characterised in that each internal preliminary decoder unit (IPDEC) contains $2^n$ logic gates with n inputs for either one of n address signals (Ai) or an address signal ($\overline{Ai}$) complementary thereto, as well as a further input for the test-enable signal ($\overline{TE}$) which deactivates the output of each gate regardless of the signal combination currently present at the remaining n inputs.

3. Multi-stage integrated decoder device according to Claim 1 or 2, characterised in that test signals (TEST1, TEST2), whose logic levels can be set independently of one another, are connected to the potential lines (Pot1, Pot2).

4. Multi-stage integrated decoder device according to Claim 3, characterised in that the test signals (TEST1, TEST2) are output signals of a CMOS inverter in each case which receives at its input a test auxiliary signal ($\overline{TEST1}$, $\overline{TEST2}$) in each case and the source of which is connected between supply potential (VCC) and reference potential (VSS).

5. Multi-stage integrated decoder device according to one of the preceding claims, characterised in that at least one group of outputs, up to a maximum of all the outputs (Y4j, ...), of each selection decoder (SDEC) is connected via the source terminal of the respective associated transfer transistor (TT) to its own potential line (Pot1, Pot2, Pot3, Pot4), and in that these potential lines (Pot1, Pot2, Pot3, Pot4) have independently of one another in each case one of two mutually complementary logic levels.

6. Multi-stage integrated decoder device according to one of Claims 1 to 5, characterised in that, instead of the two potential lines (Pot1, Pot2), it has only a single potential line (Pot) which may have one of two mutually complementary logic levels, and in that each output (Y4j, Y4j + 1, ...) of each selection decoder (SDEC) is connected via the source terminal of a transfer transistor (TT) to this potential line (Pot).

**Revendications**

1. Dispositif de décodage intégré à étages multiples, comportant au moins
   - un dispositif formant prédécodeur (PDEC) pourvu d'un précécodeur de sélection (SPDEC) et d'unités internes de prédécodage (IPDEC),
     - le prédécodeur de sélection et chaque unité interne de prédécodage sont réalisés sous la forme de décodeurs 1-parmi-n, et
   - un dispositif de décodage principal (MNDEC) à plusieurs décodeurs de sélection (SDEC) et à plusieurs décodeurs internes (IDEC),
   caractérisé par les particularités suivantes:
     - à toutes les unités internes de prédécodage (IPDEC) est envoyé un signal de validation de test (` T`E), qui, lors de l'activation, désactive tous les signaux de sortie (Z4,Z5,Z6,Z7;Z8,...; ...;Z2(N-1), ...,Z2(N-1) + 3) de toutes les unités internes de prédécodage (IPDEC),
   - une première moitié (Y4j, Y4j + 2) des sorties de chaque décodeur de sélection (SDEC) est raccordée par l'intermédiaire des bornes de source de transistors de transfert (TT) à un premier conducteur de potentiel (Pot1), et une seconde moitié (Y4j + 1, Y4j + 3) des sorties de chaque décodeur de sélection (SDEC) est raccordée par l'intermédiaire de bornes de source de transistors de transfert (TT) à un second conducteur de potentiel (Pot2),
   - les deux potentiels (Pot1,Pot2) possèdent, indépendamment l'un de l'autre, l'un de deux niveaux logiques complémentaires entre eux.

2. Dispositif de décodage intégré à plusieurs étages suivant la revendication 1, caractérisé par le fait que chaque unité interne de prédécodage (IPDEC) comporte $2^n$ portes logiques à n entrées soit pour l'un de n signaux d'adresses (Ai), soit pour un signal d'adresse (` A` i) complémentaire au précédent, ainsi qu'une autre entrée pour le signal de validation de test (` T` E), qui désactive la sortie de chaque porte indépendamment de la combinaison de signaux actuellement appliquée aux autres n entrées.

3. Dispositif de décodage intégré à plusieurs étages suivant la revendication 1 ou 2, caractérisé par le fait qu'aux conducteurs de potentiel (Pot1, Pot2) sont appliqués des signaux de test (TEST1, TEST2), dont les niveaux logiques peuvent être réglés indépendamment l'un de l'autre.

4. Dispositif de décodage intégré à plusieurs étages suivant la revendication 3, caractérisé par le fait que les signaux de test (TEST1, TEST2) sont des signaux provenant d'inverseurs CMOS respectifs qui reçoivent, côté entrée, des signaux auxiliaires respectifs de test (` T` E` S` T` 1, ` T` E` S` T` 2) et sont raccordés, côté source, entre un potentiel d'alimentation (VCC) et un potentiel de référence (VSS).

5. Dispositif de décodage intégré à plusieurs étages suivant l'une des revendications précédentes, caractérisé par le fait qu'au moins un groupe de sortie ou au maximum chacune des sorties (Y4j,...) de chaque décodeur de sélection (SDEC) est raccordé, au moyen de la borne de source du transistor de transfert associé respectif (TT), à un conducteur séparé de potentiel (Pot1, Pot2, Pot3, Pot4), et que ces conducteurs de potentiel (Pot1, Pot2, Pot3, Pot4) possèdent, indépendamment les uns des autres, l'un de deux niveaux logiques complémentaires entre eux.

6. Dispositif de codage intégré à plusieurs étages suivant l'une des revendications 1 à 5, caractérisé par le fait qu'il possède, à la place des deux conducteurs de potentiel (Pot1, Pot2), un seul conducteur de potentiel (Pot) qui possède au choix l'un de deux niveaux logiques complémentaires l'un à l'autre, et que chaque sortie (Y4j, Y4j + 1,...) de chaque décodeur de sélection (SDEC) est raccordée, par l'intermédiaire de la borne de source d'un transistor de transfert (TT), à ce conducteur de potentiel (Pot).

FIG 1

# FIG 2

# FIG 3

FIG 4

EP 0 282 975 B1

FIG 5

FIG 6